# EUROPEAN PATENT SPECIFICATION

(11) **EP 3 719 946 B1**
(45) Date of publication and mention of the grant of the patent: **02.08.2023**
(21) Application number: 20164812.8
(22) Date of filing: 23.03.2020
(51) Int. Cl.: H02H 1/00, H02H 3/08

(54) **POWER INTERRUPTION METHOD AND DEVICE BASED ON PERIODIC MEASUREMENT OF INSTANTANEOUS POWER LEVEL**
VERFAHREN UND VORRICHTUNG ZUR LEISTUNGSUNTERBRECHUNG BASIEREND AUF PERIODISCHER MESSUNG DES MOMENTANEN LEISTUNGSPEGELS
PROCÉDÉ ET DISPOSITIF D'INTERRUPTION DE PUISSANCE BASÉS SUR LA MESURE PÉRIODIQUE DU NIVEAU DE PUISSANCE INSTANTANÉE

(30) Priority: 01.04.2019 KR 20190037745
(43) Date of publication of application: 07.10.2020
(73) Proprietor: Cheil Electric Wiring Devices Co., Ltd., Busan 49437 (KR)
(72) Inventor: LEE, Jun Bae, 08018 Seoul (KR); KIM, Yong Gyu, 44956 Ulsan (KR)
(74) Representative: Mammel und Maser Patentanwälte PartG mbB

(56) References cited:
- US-A1- 2005 225 909
- US-A1- 2010 324 747
- US-A1- 2016 013 630

## Description

### TECHNICAL FIELD

The present invention relates to a power interruption method and a power interruption device which cut off the supply of power in order to protect a load to be powered and perform fast and accurate power cut-off through measurement of instantaneous overcurrent or overcurrent caused due to electric leakage/short-circuit at a load side.

### BACKGROUND ART

In general, a power interruption device such as a short circuit breaker is installed in distribution boards such as homes, shopping malls, factories, offices, department stores, etc., and electromagnets or bimetals operate according to overcurrent generated in the case of a short circuit on a load side, a cable short circuit, etc., and are turned off so that a contact with an electric cable leading from a power supply line to an internal load is separated, thereby interrupting the supply of power to the internal load. Typically, the short circuit breaker uses a zero-phase current transformer (ZCT) having a ring structure. When test current is applied or load-side electric leakage current is generated, the ZCT senses the test current or the load-side electric leakage current to allow a trip device to operate to cut off the connection between an incoming terminal of the power supply line and a load terminal connected to the internal load, thereby interrupting the power supply to the internal load. Further, typically, in the distribution board, load-side instantaneous overcurrent or overvoltage is detected together with the short circuit breaker to interrupt the power supply to the load.

However, there is a limitation to use a conventional instantaneous power interrupting method. For example, in that when a value measured in a current transformer (CT) increases, whether the measured value exceeds a predetermined threshold is not rapidly and accurately determined, and as a result, appropriate power interruption for protecting a subsequent circuit is not performed.

As a related prior document, Korean Patent Application No. 10-2012-0122027 (December 31, 2012) may be referred to.

US 2010 324 747 A1 discloses a composite electric circuit breaker and a method thereof. The circuit breaker is configured to detect signals regarding arc faults, overcurrent, and earth leakage. Arcs and electric currents are detected by a current transformer and earth leakage is detected by a zero phase current transformer. A variation of electric current, the number of arcs which are generated per a unit time, a present electric current value, and electric current earth leakage are combined to judge whether arc faults occur to then interrupt an electric power supply. Temperature is measured on a printed circuit board, and if temperature rise occurs, the electric power supply is interrupted, and an interruption cause is displayed.

### SUMMARY OF THE INVENTION

The objective technical problem to be solved can be considered to overcome or at least to reduce the disadvantages according to the prior art. The problem is solved by the subject matter of the independent claims.

Accordingly, the present invention has been made in an effort to provide a power interruption method and a power interruption device which accurately determine, when a value measured by a current transformer (CT), a voltage detector, etc., is input into a main control unit, whether the measured value is a value equal to or more than a predetermined threshold during a digital analysis processing process to effectively protect a load which receives power by rapid and accurate power interruption for load-side instantaneous overcurrent or overcurrent caused by electric leakage/short-circuit.

A power interruption method by a power interruption device is provided according to the subject matter of claim 1.

The power interruption method may further include, in which the power is AC power, generating the target signal by rectifying the detection signal before generating the control signal.

The interval between the time points when the signal magnitude level is the same may be determined within a semi-period of the AC power and the interval may be determined within 6 msec, preferably 4 msec from a zero-crossing point of the ascending signal for 60 Hz AC power as the power.

In the generating of the control signal, through a comparison between the interval and a threshold for the instantaneous trip or the leakage trip for the target signal, power supply to the load may be effectively interrupted for instantaneous overcurrent or overcurrent due to electric leakage or short-circuit at the load side.

The control signal may be generated according to whether the interval between the time points when the predetermined signal magnitude level for one or a plurality of detection signals among the respective detection signals by the ZCT, the current transformer, or the voltage detector is the same satisfies a condition.

Another power interruption method by a power interruption device is provided according to the subject matter of claim 5.

The power interruption method may further include, in which the power is AC power, generating the target signal by rectifying the detection signal before generating the control signal.

A temporal length of the saturation width may be determined based on the ADC value of the target signal within a semi-period of the power.

In the generating of the control signal, a change amount da of the ADC value is calculated every sampling period dt for the ADC value of the target signal and a cumulative value of da/dt is calculated to generate the control signal based on the saturation width for a time for which the cumulative value is maintained within a predetermined range before the cumulative value decreases after increasing.

For example, by using a characteristic that in a time change shift waveform of the ADC value, a dimension of a semi-period waveform of the power on a time axis increases until the saturation occurs and the dimension of the waveform decreases after the saturation and as a magnitude of the detection signal increases in a saturation state, the saturation width and the dimension of the waveform decrease and a phase of the waveform is close to a zero-crossing point of the ascending signal, the control signal is generated for the power having large power even when applying the current transformer having a small capacity and the corresponding ADC to interrupt power supply to the load.

The power is AC power, and before the generating of the control signal, the target signal is acquired by rectifying the detection signal, and the control signal uses the accumulated value after resetting the AC power every semi-period.

In the generating the control signal, by determining whether a saturated digital value of a predetermined limit value or more is equal to or more than a threshold for the instantaneous trip or leakage trip during a digital analysis processing process for the target signal, power supply to the load may be effectively interrupted for instantaneous overcurrent or overcurrent due to leakage or short-circuit at the load side.

The control signal may be generated according to whether the saturation width for one or a plurality of detection signals among the respective detection signals by the ZCT, the current transformer, or the voltage detector satisfies a condition.

The power interruption method may further include storing data of the ADC value of the target signal during a predetermined period before the instantaneous trip or leakage trip in a memory device.

The power interruption method may further include displaying a text or graph for the data of the ADC value of the target signal on a display device in real time.

A power interruption device is provided according to the subject matter of claim 13.

According to a power interruption method and a power interruption device according to embodiments of the present invention, when a target signal measured by using a current transformer (CT), a voltage detector, etc., is input into a main control unit, whether to satisfy a threshold condition for instantaneous trip or leakage trip for a target signal during a digital analysis processing process is rapidly determined in a semi-period to effectively interrupt a power supply to a load for instantaneous overcurrent or overcurrent by electric leakage or short-circuit at a load side.

According to a power interruption method and a power interruption device according to embodiments of the present invention, when a target signal measured by using a current transformer (CT), a voltage detector, etc., is input into a main control unit, whether a saturated digital value of a predetermined limit value or more is equal to or more than a threshold is accurately determined during the digital analysis processing process to effectively protect a load which receives power by rapid and accurate power interruption for instantaneous overcurrent or overcurrent by electric leakage or short-circuit at the load side.

### BRIEF DESCRIPTION OF THE DRAWINGS

In order to help understand the present invention, the accompanying drawings which are included as a part of the Detailed Description are used to provide embodiments of the present invention and describe the technical spirit of the present invention together with the Detailed Description.
FIG. 1 is a diagram for describing a power interruption device according to an exemplary embodiment of the present invention.
FIG. 2 is a flowchart for describing an operation of a power interrupting device according to an exemplary embodiment of the present invention.
FIG. 3 is a diagram for describing AC power exemplified in the present invention.
FIG. 4 is a diagram for describing a rectified signal output from a rectification unit exemplified in the present invention.
FIG. 5 is a diagram for describing overcurrent determination using an interval between time points having the same predetermined signal magnitude level in a main control unit according to an exemplary embodiment of the present invention.
FIG. 6 is a diagram for describing calculation of a saturation width for a saturation time in an ADC value of current/voltage in a main control unit according to an exemplary embodiment of the present invention.
FIG. 7 is a diagram for describing a concept of determination of overcurrent depending on a cumulative value of da/dt in a main control unit according to an exemplary embodiment of the present invention.

### DETAILED DESCRIPTION

Hereinafter, the present invention will be described in detail with reference to the accompanying drawings. In this case, the same components in each drawing are represented by the same reference numerals as much as possible. In addition, detailed descriptions of already known functions and/or configurations are omitted. The following description focuses on parts necessary for understanding the operation according to various embodiments, and descriptions of elements that may obscure the gist of the description are omitted. In addition, some components of the drawings may be exaggerated, omitted, or schematically illustrated. The size of each component does not entirely reflect the actual size, and thus the contents described herein are not limited by the relative size or spacing of the components drawn in the respective drawings.

In describing the exemplary embodiments of the present invention, a detailed description of the known art related to the present invention will be omitted when it is judged that the detailed description may unnecessarily make the gist of the present invention unclear. In addition, terms to be described below as terms which are defined in consideration of functions in the present invention may vary depending on the intention of a user or an operator or usual practice. Accordingly, the terms need to be defined based on contents throughout this specification. Terms used in a detailed description are to just describe the exemplary embodiments of the present invention and should not be restrictive in any way. Unless specifically used otherwise, the expression of a singular form includes a meaning of a plural form. In the present description, an expression such as "including" or "comprising" is intended to indicate certain features, numbers, steps, operations, elements, some or combinations thereof and should not be construed to preclude the presence or possibility of one or more other features, numbers, steps, operations, elements, some or combinations thereof in addition to the described things.

Terms including first, second, and the like are used for describing various constituent elements, but the constituent elements are not limited by the terms and the terms are used only for distinguishing one constituent element from other constituent elements.

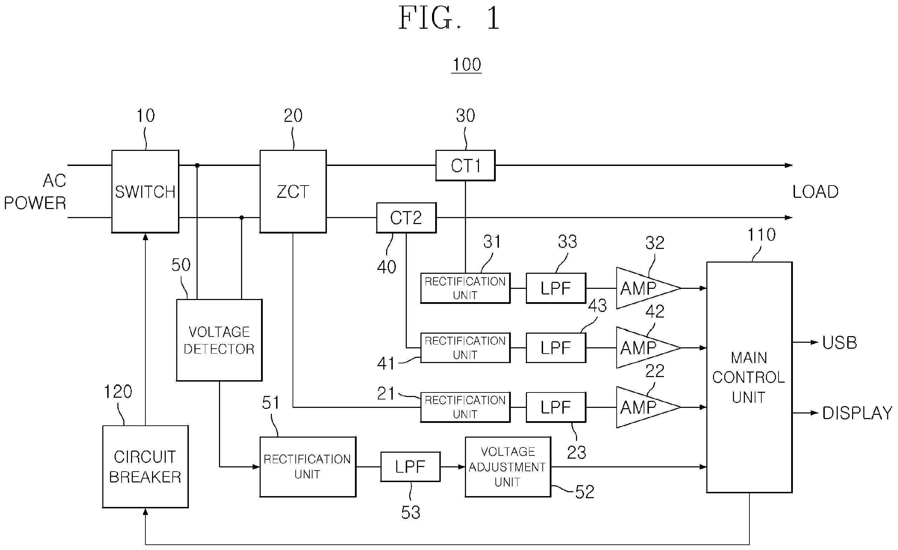

FIG. 1 is a diagram for describing a power interrupting device 100 according to an exemplary embodiment of the present invention.

Referring to FIG. 1 , the power interrupting device 100 according to an exemplary embodiment of the present invention includes a zero phase current transformer (ZCT) 20, current transformers 30 and 40, and a voltage detector 50 coupled to a power supply line supplying power to a load and includes rectification units 21, 31, 41, and 51 for signal transformation or adjustment, amplifiers 22, 32, and 42, and a voltage adjustment unit 52. Between the rectification units 21, 31, 41, and 51 and the amplifiers 22, and 32, and 42 or the voltage adjustment unit 52, low pass filters (LPF) 23, 33, and 43, and 53 for removing high frequency noise through low pass filtering may be provided, respectively. Further, the power interrupting device 100 includes a main control unit 110, a circuit breaker 120, and a switch 10 for controlling whether to interrupt power supplied to a load by analyzing signals from the components.

The power interrupting device 100 is installed in distribution boards of homes, stores, factories, offices, department stores, etc., and according to overcurrent generated in the case of leakage, cable short-circuit, arc, etc., at the load side, the main control unit 110 generates a control signal and the circuit breaker 120 generates a drive signal for interrupting a power supply to the load according to the control signal, and the switch 10 accordingly drives a trip device (e.g., operating of a crossbar, a latch, etc.) to cut off a connection between an incoming terminal into which AC power comes and a load terminal connected to the load (turn off a contact between terminals to be separated), thereby interrupting the power supply to the load.

The main control unit 110 takes charge of an overall control of the components of the power interrupting device 100 and generates a control signal for an instantaneous trip (driving of the trip device for instantaneous overcurrent), a leakage trip (driving of the trip device for overcurrent in electric leakage), or an arc trip (driving of the trip device for overcurrent by arc) for the power supply to the load for an input target signal based on a detection signal detected by the ZCT 20, the current transformers 30 and 40, or the voltage detector 50. The main control unit 110 may be constituted by hardware (e.g., a micro control unit (MCU), a central control unit (CPU), etc.) such as a semiconductor processor, etc., for the overall control of the components and may also be implemented to operate in combination with software such as an application program, etc.

The ZCT 20 has a ring structure for penetration of two power supply lines (e.g., a hot line and a neutral line) (generally including penetration of a test line for a test) and the ZCT 20 senses current which flows on two power supply lines (e.g., the hot line and the neutral line) penetrating the ring structure between the switch 10 and the load to generate an electrical signal corresponding to the sensed current, such as overcurrent generation, etc., as the detection signal. For example, with generation of instantaneous overcurrent or overcurrent by electric leakage or short-circuit at the load side, when a current sum value of power supply lines penetrating the ring structure of the ZCT 20 does not become zero, the ZCT 20 generates the electrical signal corresponding thereto and the corresponding signal of the ZCT 20 as a target signal for a power instantaneous trip, a leakage trip, or the arc trip is input into the main control unit 110 via the rectification unit 21 for full wave rectification, such as a bridge diode, etc., and the amplifier 22 for amplifying a signal at a predetermined level.

In the present invention, it is exemplified and described that incoming AC power is the hot line and the neutral line, but the present invention is not limited thereto and in some cases, when power such as 3-phase 3-wire/4-wire is supplied to the load, the incoming AC power may be similarly applied even to 3 power lines, 4 power lines (e.g., 3-phase R, S, and T and neutral line N), etc.

The current transformers 30 and 40 generate an electrical signal corresponding to a magnitude of current for each power supply line as the corresponding detection signal. The corresponding electrical signal of each of the current transformers 30 and 40 may be input into the main control unit 110 via a rectification unit 31/41 such as a bridge diode, etc., and an amplifier 32/42 for amplifying the signal to a predetermined level as the target signal for the instantaneous trip, the leakage trip, or the arc trip.

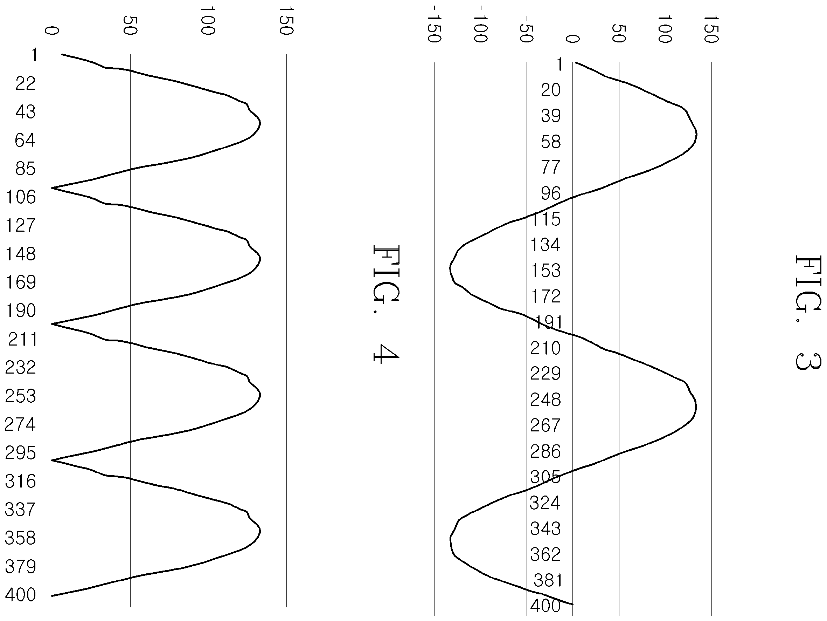

The voltage detector 50 generates an electrical signal corresponding to a magnitude (e.g., 220 V) of voltage in two power supply lines as the corresponding detection signal as illustrated in FIG. 3. The corresponding electrical signal of the voltage detector 50 may be rectified by the rectification unit 51 such as the bridge diode, etc., as illustrated in FIG. 4 and the voltage adjustment unit 52 may adjust the signal at a predetermined level for inputting the signal into the main control unit 110 and input the adjusted signal into the main control unit 110 as the target signal for the instantaneous trip, the leakage trip, or the arc trip.

In the present invention, the main control unit 110 analyzes the corresponding target signal input after being processed by the rectification units 21, 31, 41, and 51 and the amplifiers 22, 32, and 42/the voltage adjustment unit 52 based on the detection signal detected by the ZCT 20, the current transformer 30/40, or the voltage detector 50 and generates the control signal for the instantaneous trip or the leakage trip for the power supply to the load. In other words, the main control unit 110 generates an analog to digital converter (ADC) value of the corresponding target signal, and as a result, whether to satisfy a threshold condition for instantaneous trip or leakage trip for a target signal during a digital analysis processing process is rapidly determined in a semi-period to effectively interrupt a power supply to the load for instantaneous overcurrent or overcurrent by electric leakage or short-circuit at the load side. For example, with overcurrent generated in the case of electric leakage, cable short-circuit, arc, etc., at the load side, the main control unit 110 generates a control signal and the circuit breaker 120 generates a drive signal for interrupting a power supply to the load according to the control signal, and the switch 10 accordingly drives a trip device (e.g., operating of a crossbar, a latch, etc.) to cut off a connection between an incoming terminal into which AC power comes and a load terminal connected to the load (turn off a contact between terminals to be separated), thereby interrupting the power supply to the load.

The main control unit 110 may store data of the ADC value of the target signal during a predetermined period (e.g., within 1 minute such as 10 seconds, 20 seconds, 30 seconds, etc.) before the instantaneous trip, the leakage trip, or the arc trip in a memory. For example, the data of the ADC value of the target signal during a predetermined period is stored in a volatile memory connected to a Universal Serial Bus (USB) port, and as a result, a cause analysis of the interruption occurrence and a follow-up measure may be applied to be rapidly taken.

The main control unit 110 may output data so as to display the power interruption depending on occurrence of the instantaneous trip, the leakage trip, or the arc trip on a display device (e.g., LCD, LED, etc.) in real-time in a text or graph form for the data of the ADC value of the corresponding target signal. According to the display, in order to determine the corresponding data when the power is interrupted, it may be easily verified whether the overcurrent is generated due to serial arc or parallel arc, or overload immediately through the display device (e.g., LCD, LED, etc.) even though an external interface is not connected.

In particular, in the present invention, the overcurrent by the electric leakage, cable short-circuit, arc, etc., at the load side, is rapidly tripped within the semi-period of the AC power to effectively prepare for disasters such as damage to a subsequent circuit, fire, etc., due to the overcurrent.

For example, the main control unit 110 generates the ADC value of the target signal for the corresponding current/voltage detection to generate the control signal for the power interruption by using that an interval between time points when a predetermined signal magnitude level is the same in continuous descending and ascending signals (continuation of the descending signal and the ascending signal or continuation of the ascending signal and the descending signal) of the ADC value of the corresponding target signal is changed when overcurrent is generated. In other words, when the target signal measured by using the current transformer 30/40, the voltage detector 50, etc., is input into the main control unit 110, whether to satisfy a threshold condition for the instantaneous trip or leakage trip for a target signal during a digital analysis processing process is rapidly determined in the semi-period to effectively interrupt a power supply to the load for instantaneous overcurrent or overcurrent by electric leakage or short-circuit at the load side.

As another method, the main control unit 110 generates the ADC value of the target signal for the corresponding current/voltage detection to determine whether a saturated digital value depending on a specification (e.g., 8 bits) of the ADC included in the main control unit is generated and generate the control signal for the power interruption by using that a saturation width for a saturation time is larger than a predetermined threshold. In other words, when a target signal measured by using the current transformer 30/40, the voltage detector 50, etc., is input into the main control unit 110, whether a saturated digital value of a predetermined limit value or more is equal to or more than a threshold is accurately determined during the digital analysis processing process to effectively protect a load which receives power by rapid and accurate power interruption for instantaneous overcurrent or overcurrent by electric leakage or short-circuit at the load side.

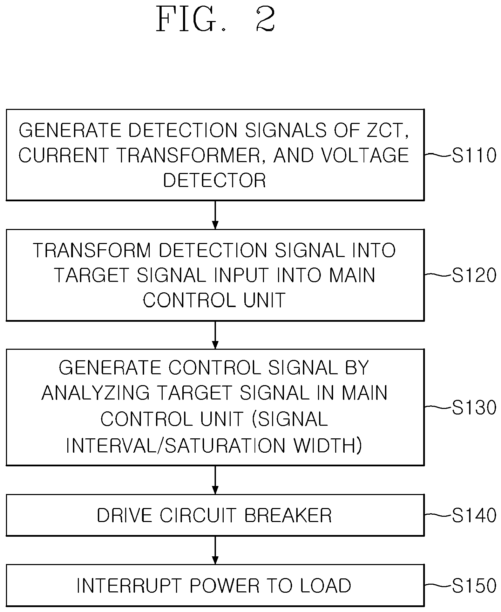

Hereinafter, an operation of the power interrupting device 100 according to an exemplary embodiment of the present invention will be described in more detail with reference to a flowchart of FIG. 2 .

FIG. 2 is a flowchart for describing an operation of a power interrupting device 100 according to an exemplary embodiment of the present invention.

First, the ZCT 20, the current transformers 30 and 40, and the voltage detector 50 generate each detection signal (S110). The ZCT 20 senses current which flows on two power supply lines (e.g., a hot line and a neutral line) penetrating the ring structure between the switch 10 and the load and generates an electrical signal corresponding to the sensed current, such as overcurrent generation as the detection signal. The current transformers 30 and 40 generate an electrical signal corresponding to a magnitude of current for each power supply line as the corresponding detection signal. The voltage detector 50 generates an electrical signal corresponding to a magnitude (e.g., 220 V) of voltage in two power supply lines as the corresponding detection signal as illustrated in FIG. 3 .

Rectification or amplification of the detection signal generated in each of the ZCT 20, the current transformers 30 and 40, and the voltage detector 50 is adjusted and the detection signal as the target signal is input into the main control unit 110 (S120). The corresponding detection signal generated by the ZCT 20 is input into the main control unit 110 via the rectification unit 21 such as the bridge diode, etc., and the amplifier 22 for amplifying the signal at a predetermined level as the target signal for the instantaneous trip, the leakage trip, or the arc trip. The corresponding detection signals generated by each of the current transformers 30 and 40 may be input into the main control unit 110 via the rectification unit 31/41 such as the bridge diode, etc., and the amplifier 32/42 for amplifying the signal at a predetermined level as the target signal for the instantaneous trip, the leakage trip, or the arc trip. The corresponding detection signal generated by the voltage detector 50 may be rectified by the rectification unit 51 such as the bridge diode, etc., as illustrated in FIG. 4 and the voltage adjustment unit 52 may adjust the signal to a predetermined level for inputting the signal into the main control unit 110 and input the adjusted signal into the main control unit 110 as the target signal for the instantaneous trip, the leakage trip, or the arc trip.

The main control unit 110 analyzes the corresponding target signal input while being processed by the rectification units 21, 31, 41, and 51 and the amplifiers 22, 32, and 42/the voltage adjustment unit 52 based on the detection signal detected by the ZCT 20, the current transformer 30/40, or the voltage detector 50 and generates the control signal for the instantaneous trip, the leakage trip, or the arc trip for the power supply to the load (S130).

The main control unit 110 generates an analog to digital converter (ADC) value of the corresponding target signal, and as a result, whether to satisfy a threshold condition for instantaneous trip, electric leakage trip, or arc trip for a target signal during a digital analysis processing process is rapidly determined in a semi-period to effectively interrupt a power supply to the load for instantaneous overcurrent or overcurrent by electric leakage or short-circuit at the load side. In other words, in the present invention, the overcurrent by the electric leakage, cable short-circuit, arc, etc., at the load side is rapidly tripped within the semi-period of the AC power which comes in to effectively prepare for disasters such as damage to a subsequent circuit, fire, etc., due to the overcurrent.

For example, the main control unit 110 generates the ADC value of the target signal for the corresponding current/voltage detection to generate the control signal for the power interruption by using that an interval between time points when a predetermined signal magnitude level is the same in continuous descending and ascending signals (continuation of the descending signal and the ascending signal or continuation of the ascending signal and the descending signal) of the ADC value of the corresponding target signal is changed when overcurrent is generated.

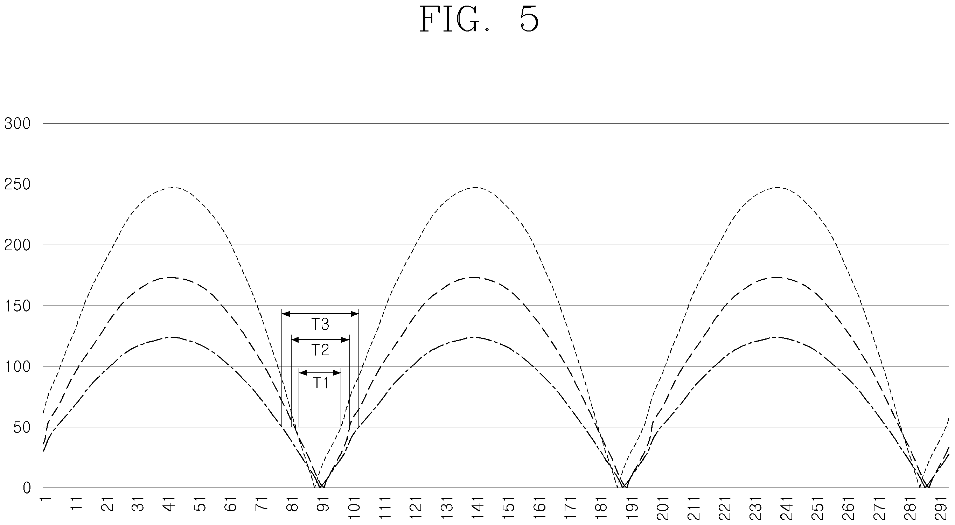

FIG. 5 is a diagram for describing overcurrent determination using an interval between time points having the same predetermined signal magnitude level in the main control unit according to an exemplary embodiment of the present invention.

When the main control unit 110 calculates the ADC value for the target signal of the corresponding current/voltage for a sampling time 0, 1, 2, 3, etc., (e.g., an interval of 1/100 of semi-period 8.3 msec in power 60 Hz) as illustrated in FIG. 5 , if the corresponding current/voltage increases in the same period, an interval between time points when a predetermined signal magnitude level (e.g., ADC value of 50) is the same in the continuous descending signal and ascending signal decreases to T3, T2, T1, etc. Similarly even in a continuous part of the ascending signal and the descending signal, when the corresponding current/voltage increases, the corresponding interval decreases. Accordingly, through a comparison between the interval between the time points when the predetermined signal magnitude level (e.g., ADC value of 50) is the same in the continuous descending signal and ascending signal and a predetermined threshold (e.g., T1) for the instantaneous trip or the electric leakage trip for the corresponding target signal, when the corresponding interval is smaller than the threshold, the corresponding current is recognized as the instantaneous overcurrent or overcurrent by the electric leakage or short-circuit to effectively interrupt the power supply to the load.

In other words, when the target signal measured by using the current transformer 30/40, the voltage detector 50, etc., is input into the main control unit 110, whether to satisfy a threshold condition for instantaneous trip or leakage trip for a target signal during a digital analysis processing process is rapidly determined in the semi-period to effectively interrupt a power supply to the load for instantaneous overcurrent or overcurrent by electric leakage or short-circuit at the load side.

In the current/voltage measurement method of the present invention, as an ADC sample is higher, the current/voltage may be precisely measured and since the corresponding interval part is a part to which the load is not actually applied, the current or voltage may be measured without influencing a measurement device or a subsequent circuit. When the characteristic is used, since input current or voltage may be measured while an actual load is not applied, a large power signal may be detected without influencing the load through rapid interruption. Further, in a conventional method, an input signal of a minimum semi-period (8.3 ms) should be monitored in order to calculate a power amount, but current of the target signal may be monitored, but in the present invention, overcurrent may be detected and interrupted within 6 msec, preferably within 4 msec from a zero-crossing point of the ascending signal for 60 Hz AC power.

In such an example, a case where the main control unit 110 analyzes the corresponding signal for the detection signal of any one of the ZCT 20, the current transformer 30/40, or the voltage detector 50 and generates the control signal for the instantaneous trip or leakage trip for the power supply to the load is described as an example, but the present invention is not limited thereto and in some cases, the control signal may be generated by considering whether to satisfy such a condition for the target signals of a plurality of two or more selected detection signals among the detection signals of the ZCT 20, the current transformer 30/40, and the voltage detector 50. For example, through a comparison between the interval between the time points when the predetermined signal magnitude level (e.g., ADC value of 50) is the same in the continuous descending signal and ascending signal and each threshold, when all corresponding intervals are smaller than the respective thresholds, the supply of the power to the load may be designed to be interrupted for the instantaneous overcurrent or overcurrent by the electric leakage or short-circuit at the load side.

There is a method for determining total power generated based on a monitoring value for an entire region of the semi-period at the time of detecting voltage/current for each semi-period by using a full-wave rectification circuit in the related at the time of measuring instantaneous power, but in the present invention, it is possible to easily determine the instantaneous power by monitoring a pulse width determined approximately at a predetermined level from a point near a zero crossing point of the detection signal.

As another method, the main control unit 110 generates the ADC value of the target signal for the corresponding current/voltage detection to determine whether a saturated digital value depending on a specification (e.g., 8 bits) of the ADC included in the main control unit is generated and generate the control signal for the power interruption by using that a saturation width for a saturation time is larger than a predetermined threshold.

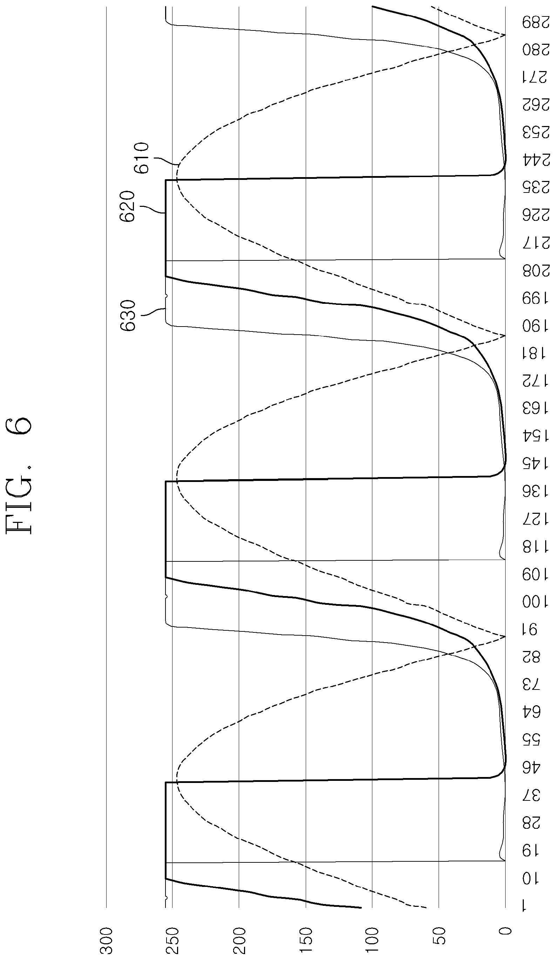

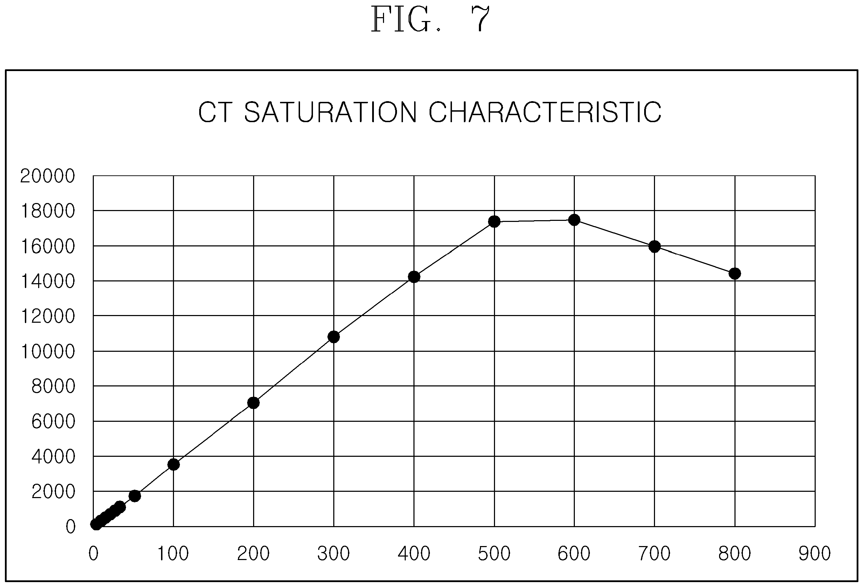

FIG. 6 is a diagram for describing calculation of a saturation width for a saturation time in an ADC value of current/voltage in the main control unit according to an exemplary embodiment of the present invention. FIG. 7 is a diagram for describing a concept of determination of overcurrent depending on a cumulative value of da/dt in the main control unit according to an exemplary embodiment of the present invention.

When the main control unit 110 calculates ADC values for target signals 610, 620, and 630 of the corresponding current/voltage for the sampling time 0, 1, 2, 3, etc., (e.g., an interval of 1/100 during a semi-period of 8.3 msec at power 60 Hz), as illustrated in FIG. 6 , if the corresponding current/voltage increases at the same period and the corresponding current/voltage is equal to or more than a predetermined degree, the corresponding current/voltage becomes a saturation state in which the target signals may not be distinguished by a specification (e.g., 8 bits = 256 grays) of the ADC included in the main control unit 110 and when a saturation width (a saturated time width) for a saturation time is larger than a predetermined threshold, the overcurrent is recognized as the instantaneous overcurrent or overcurrent by the electric leakage or short-circuit, thereby effectively interrupting the power supply to the load at this time.

In order to use such a point, the main control unit 110 calculates a change amount da of the corresponding ADC value every sampling period dt for the ADC value of the corresponding signal and calculates a cumulative value of da/dt to generate the control signal based on a saturation width for a time maintained within a predetermined range (for which fluctuation may be permitted within a predetermined range) before the corresponding cumulative value decreases after increasing. FIG. 7 illustrates an example of a cumulative value of da/dt of the corresponding target signal as the corresponding current/voltage increases as 10, 20, ..., 50, 100, 200, 300, etc., and it can be seen that when there is the saturation as represented by reference numerals 620 and 630 of FIG. 6 , the saturation width for the time maintained within the predetermined range before the cumulative value of da/dt decreases after increasing is shown.

However, since a form is repeated in which the signal ascends from descending every semi-period of the AC power, the cumulative value of da/dt also has the same form, and as a result, the cumulative value of da/dt is reset (e.g., becomes zero) every semi-period of the incoming AC power for convenience of data management to calculate the cumulative value of da/dt repeatedly every semi-period of the AC power, thereby preferably generating the control signal.

As such, when a target signal measured by using the current transformer 30/40, the voltage detector 50, etc., is input into the main control unit 110, whether a saturated digital value of a predetermined limit value or more is equal to or more than a threshold is accurately determined during the digital analysis processing process to effectively protect a load which receives power by rapid and accurate power interruption to the load for instantaneous overcurrent or overcurrent by electric leakage/short-circuit at the load side.

In this case, in a time shift waveform of the ADC value illustrated in FIG. 6 , a dimension of a semi-period waveform of the AC power on a time axis increases until the saturation occurs and the dimension of the corresponding waveform decreases after the saturation and as the magnitude of the corresponding detection signal increases in a saturation state, the saturation width and the dimension of the waveform decrease and a phase of the corresponding waveform is close to the zero crossing point of the ascending signal as represented by reference numerals 620 and 630. In the present invention, by using the characteristic, even when applying the corresponding ADC of a small capacity in the current transformer 30/40 and the main control unit 110 having a small capacity, such a control signal is generated for large power to effectively interrupt the power supply to the load.

In such an example, a case where the main control unit 110 analyzes the corresponding target signal for the detection signal of any one of the ZCT 20, the current transformer 30/40, or the voltage detector 50 and generates the control signal for the instantaneous trip or leakage trip for the power supply to the load is described as an example, but the present invention is not limited thereto and in some cases, the control signal may be generated by considering whether to satisfy such a condition for the target signals of a plurality of two or more selected detection signals among the detection signals of the ZCT 20, the current transformer 30/40, and the voltage detector 50. For example, through a comparison between a saturation width (a saturated time width) for a time for which the ADC values of the target signals are saturated and each predetermined threshold, when all corresponding saturation widths are larger than each threshold, the supply of the power to the load may be designated to be interrupted for the instantaneous overcurrent or the overcurrent due to the electric leakage or short-circuit at the load side. Here, the respective thresholds may be the same as each other or may be different from each other.

As such, with the overcurrent generated in the case of electric leakage, cable short-circuit, arc, etc., at the load side, the main control unit 110 generates a control signal and the circuit breaker 120 generates a drive signal for interrupting a power supply to the load according to the control signal (see S140 of FIG. 12), and the switch 10 accordingly drives a trip device (e.g., operating of a cross-bar, a latch, etc.) to cut off a connection between an incoming terminal into which AC power comes and a load terminal connected to the load (turn off a contact between terminals to be separated), thereby interrupting the power supply to the load (see S150 of FIG. 2).

The main control unit 110 may store data of the ADC value of the target signal during a predetermined period (e.g., within 1 minute such as 10 seconds, 20 seconds, 30 seconds, etc.) before the instantaneous trip, the leakage trip, or the arc trip in a memory. For example, the data of the ADC value of the target signal during a predetermined period is stored in a volatile memory connected to a USB port, and as a result, a cause analysis of the interruption occurrence and a follow-up measure may be applied to be rapidly taken. Furthermore, the main control unit 110 may output data for displaying the power interruption depending on occurrence of the instantaneous trip, the leakage trip, or the arc trip on a display device (e.g., LCD, LED, etc.) in real-time in a text or graph form for the data of the ADC value of the corresponding signal. According to the display, in order to determine the corresponding data when the power is interrupted, it may be easily verified whether the overcurrent is generated due to serial arc or parallel arc, or overload immediately through the display device (e.g., LCD, LED, etc.) even though an external interface is not connected.

In general, current or voltage for a power input is measured by a sum of peak detection during one period or an input value. In order to measure voltage or current based on a power 60 Hz frequency, it is generally possible to measure the power only by monitoring an input signal of 16.6 ms. Therefore, even though an instantaneous large power signal is input, there is a limit in that a result value may be obtained only by monitoring a result of a minimum of 16 ms or more. In particular, in the case of a short-circuit test of the breaker, when electronic monitoring is performed for an input of 2500 A, if the input of 16 ms is monitored, a circuit of a mechanical part may be damaged, and as a result, the breaker is implemented by a scheme of interrupting the large power signal by a magnetic scheme using an electrical magnetic signal at the time of inputting the large power signal in the related art.

In the present invention, such a problem is solved at the time of applying the present invention to an electronic breaker. When the rectification circuit is applied to the signal input, if the power is monitored by acquiring a power signal which is repeated in the semi-period, a faster power measurement result may be obtained. When precision is required for the power measurement result, if a movement averaged result is applied, higher precision may be measured. For example, when the signal is detected by using a current transformer (CT) having precision of 1%, if an average for the signal during 10 periods is applied, the precision may increase to 0.1%.

A home electric leakage circuit breaker is divided into an instantaneous test and a short-circuit test. In the case of home electric leakage circuit breaker type C, an interruption time of 0.1 seconds or longer in 5 times of rated current and an interruption time within 0.1 seconds in 10 times of the rated current are requested and a short-circuit test is a test in which the mechanical part should endure without damage for an interruption time when applying current of 2500 A. Such a test is carried out for each phase. In order to satisfy such a test, such a test is performed by application by bimetals or magnetic in the related art, but the test is unsuccessful in many cases. There is a case where in order to solve such a problem, power detection by a digital scheme is proposed, but since large power current should be detected at low current, there is a difficulty even in adaptation to the current transformer.

In the scheme proposed by the present invention, in spite of applying a current transformer having a small capacity, the overcurrent is successfully detected for large power to interrupt the power. Most current transformers have a limit in a capacity detectable according to the specification and when a signal input equal to or more than the capacity is input, distortion of the signal occurs, and as a result it is difficult to measure the current. Further, when the ADC to be detected is also set according to a large capacity, current having a small capacity may not be measured and a large-capacity large-power signal may not be measured with the small capacity. Since such a part is also a limit of an electronic breaker, there is a limit that the breaker is developed and applied by a mechanical characteristic even in the conventional scheme, but the present invention improves the limit.

As described above, according to the power interrupting device 100 according to the present invention, when a target signal measured by using the current transformer 30/40, the voltage detector 50, etc., is input into the main control unit 110, whether to satisfy a threshold condition for instantaneous trip or leakage trip for a target signal during a digital analysis processing process is rapidly determined in a semi-period to effectively interrupt a power supply to a load for instantaneous overcurrent or overcurrent by electric leakage or short-circuit at a load side. Further, whether a saturated digital value of a predetermined limit value or more is a value equal to or more than a threshold is accurately determined during the digital analysis processing process to effectively protect a load that receives the power by rapid and accurate power interruption for the instantaneous overcurrent or leakage/short-circuit current at the load side.

## Claims

1. A power interruption method by a power interruption device (100), comprising:
receiving a detection signal detected by each of a ZCT (20), a current transformer (30), or a voltage detector (50) coupled to a power supply line supplying power to a load;
generating an ADC value of a target signal input based on the detection signal;
generating a control signal for tripping depending on occurrence of an instantaneous overcurrent or a leakage overcurrent for interrupting power supply to the load for the target signal input based on the detection signal; and
interrupting the power supply to the load according to the control signal, wherein the control signal is generated based on a comparison between a) a time interval (T1, T2, T3) between time points at which a predetermined signal magnitude level of the ADC value of the target signal is the same in subsequent descending and ascending signals and b) a predetermined threshold time interval,
wherein the power is AC power,
the power interruption method being **characterized in that**
the time interval between the time points at which the signal magnitude level is the same is determined within a semi-period of the AC power.

2. The power interruption method of claim 1, further comprising:
generating the target signal by rectifying the detection signal before generating the control signal, and preferably
the interval is determined within 6 msec from a zero-crossing point of the ascending signal for 60 Hz AC power as the power.

3. The power interruption method of claim 1, wherein in the generating of the control signal, through a comparison between the interval and a threshold for the instantaneous trip or the leakage trip for the target signal, power supply to the load is effectively interrupted for instantaneous overcurrent or overcurrent due to leakage or short-circuit at the load side.

4. The power interruption method of claim 1, wherein the control signal is generated according to whether the interval between the time points when the predetermined signal magnitude level for one or a plurality of detection signals among the respective detection signals by the ZCT (20), the current transformer (30), or the voltage detector (50) is the same satisfies a condition.

5. A power interruption method by a power interruption device, comprising:
receiving a detection signal detected by each of a ZCT (20), a current transformer (30), or a voltage detector (50) coupled to a power supply line supplying power to a load;
generating an ADC value of a target signal input based on the detection signal;
generating a control signal for tripping depending on occurrence of an instantaneous overcurrent or a leakage overcurrent for interrupting power supply to the load for the target signal input based on the detection signal; and
interrupting the power supply to the load according to the control signal,
wherein the power is AC power, the power interruption method being **characterized in that** the control signal is generated based on a comparison between a) a saturation width corresponding to a saturation time interval at which a saturated digital ADC value of the target signal depending on a specification of an ADC is determined and b) a predetermined threshold time interval, and
wherein a temporal length of the saturation width is determined based on the ADC value of the target signal within a semi-period of the power.

6. The power interruption method of claim 5, further comprising:
generating the target signal by rectifying the detection signal before generating the control signal.

7. The power interruption method of claim 5, wherein in the generating of the control signal, a change amount da of the ADC value is calculated every sampling period dt for the ADC value of the target signal and a cumulative value of da/dt is calculated to generate the control signal based on the saturation width for a time for which the cumulative value is maintained within a predetermined range before the cumulative value decreases after increasing.

8. The power interruption method of claim 7, wherein by using a characteristic that in a time change shift waveform of the ADC value, a dimension of a semi-period waveform of the power on a time axis increases until the saturation occurs and the dimension of the waveform decreases after the saturation and as a magnitude of the detection signal increases in a saturation state, the saturation width and the dimension of the waveform decrease and a phase of the waveform is close to a zero- crossing point of the ascending signal, the control signal is generated for the power having large power even when applying the current transformer (30) having a small capacity and the corresponding ADC to interrupt power supply to the load.

9. The power interruption method of claim 7, wherein before the generating of the control signal, the target signal acquired by rectifying the detection signal is generated and the cumulative value calculated after resetting the AC power every semi-period is used.

10. The power interruption method of claim 5, wherein in the generating of the control signal, by determining whether a saturated digital value of a predetermined limit value or more is equal to or more than a threshold for the instantaneous trip or leakage trip during a digital analysis processing process for the target signal, power supply to the load is effectively interrupted for instantaneous overcurrent or overcurrent due to leakage or short-circuit at the load side.

11. The power interruption method of claim 5, wherein the control signal is generated according to whether the saturation width for one or a plurality of detection signals among the respective detection signals by the ZCT (20), the current transformer (30), or the voltage detector (50) satisfies a condition.

12. The power interruption method of claim 5, further comprising:
storing data of the ADC value of the target signal during a predetermined period before the instantaneous trip or leakage trip in a memory, and/or
further comprising:
displaying a text or graph for the data of the ADC value of the target signal on a display device in real time.

13. A power interruption device (100) comprising:
a ZCT (20), a current transformer (30), or a voltage detector (50) coupled to a power supply line supplying power to a load;
a main control unit (110) generating a control signal for tripping depending on occurrence of an instantaneous overcurrent or a leakage overcurrent for interrupting power supply to the load for a target signal input based on a detection signal detected by the ZCT (20), current transformer (30), or voltage detector (50), wherein an ADC value of the target signal input based on the detection signal is generated by the main control unit (110); and
a circuit breaker (120) able to interrupt the power supply to the load according to the control signal,
wherein the power is AC power,
the power interruption device being **characterized in that** the main control unit (110) is configured to generate the control signal based on a comparison between a) a time interval (T1, T2, T3) between time points at which a predetermined signal magnitude level of the ADC value of the target signal is the same in subsequent descending and ascending signals and b) a first predetermined threshold time interval, wherein the time interval between the time points at which the signal magnitude level is the same is determined within a semi-period of the AC power; or
**in that** the main control unit (110) is configured to generate the control signal based on a comparison between a) a saturation width corresponding to a saturation time interval depending on whether a saturated digital ADC value of the target signal depending on a specification of an ADC is determined and b) a second predetermined threshold time interval, wherein a temporal length of the saturation width is determined based on the ADC value of the target signal within a semi-period of the power.

## Patentansprüche

1. Verfahren zur Leistungsunterbrechung durch eine Leistungsunterbrechungsvorrichtung (100), umfassend, dass:
ein Detektionssignal empfangen wird, welches jeweils durch einen ZCT (20), einen Stromwandler (30) oder einen Spannungsdetektor (50) detektiert wird, die mit einer Leistungsversorgungsleitung gekoppelt sind, durch welche eine Last mit Leistung versorgt wird;
basierend auf dem Detektionssignal ein ADC-Wert einer Zielsignaleingabe erzeugt wird;
bei einer auf dem Detektionssignal basierenden Zielsignaleingabe ein vom Auftreten eines Momentanüberstroms oder eines leckagebedingten Überstroms abhängiges Auslöse-Steuersignal zum Unterbrechen der Leistungsversorgung der Last erzeugt wird; und
die Leistungsversorgung der Last gemäß dem Steuersignal unterbrochen wird, wobei das Steuersignal basierend auf einem Vergleich erzeugt wird zwischen a) einem Zeitintervall (T1, T2, T3) zwischen Zeitpunkten, zu denen ein vorbestimmter Signalgrößenpegel des ADC-Wertes des Zielsignals bei aufeinanderfolgenden abfallenden und ansteigenden Signalen derselbe ist und b) einem vorbestimmten Schwellenwertzeitintervall, wobei es sich bei der Leistung um AC-Leistung handelt, wobei das Verfahren zur Leistungsunterbrechung **dadurch gekennzeichnet ist, dass** das Zeitintervall zwischen den Zeitpunkten, zu denen der Signalgrößenpegel derselbe ist, innerhalb einer Halbperiode der AC-Leistung bestimmt wird.

2. Verfahren zur Leistungsunterbrechung nach Anspruch 1, ferner umfassend, dass:
das Zielsignal durch Gleichrichten des Detektionssignals erzeugt wird, bevor das Steuersignal erzeugt wird, und vorzugsweise
das Intervall innerhalb von 6 ms von einem Nulldurchgangspunkt des ansteigenden Signals für 60 Hz AC-Leistung als Leistung bestimmt wird.

3. Verfahren zur Leistungsunterbrechung nach Anspruch 1, wobei beim Erzeugen des Steuersignals, das durch einen Vergleich zwischen dem Intervall und einem Schwellenwert für die Momentanauslösung oder leckagebedingte Auslösung für das Zielsignal erfolgt, die Leistungsversorgung der Last bei lastseitigem Auftreten eines Momentanüberstroms oder eines leckage- bzw. kurzschlussbedingten Überstroms auf wirksame Weise unterbrochen wird.

4. Verfahren zur Leistungsunterbrechung nach Anspruch 1, wobei das Steuersignal in Abhängigkeit davon erzeugt wird, ob das Intervall, welches zwischen den Zeitpunkten liegt, zu denen der vorbestimmte Signalgrößenpegel für ein Detektionssignal bzw. für eine Mehrzahl von Detektionssignalen aus den von dem ZCT (20), dem Stromwandler (30) oder dem Spannungsdetektor (50) jeweils bereitgestellten Detektionssignalen derselbe ist, eine Bedingung erfüllt.

5. Verfahren zur Leistungsunterbrechung durch eine Leistungsunterbrechungsvorrichtung, umfassend, dass:
ein Detektionssignal empfangen wird, welches jeweils durch einen ZCT (20), einen Stromwandler (30) oder einen Spannungsdetektor (50) detektiert wird, die mit einer Leistungsversorgungsleitung gekoppelt sind, durch welche eine Last mit Leistung versorgt wird;
basierend auf dem Detektionssignal ein ADC-Wert einer Zielsignaleingabe erzeugt wird;
in Abhängigkeit zum Auftreten eines Momentanüberstroms oder eines leckagebedingten Überstroms ein Auslöse-Steuersignal erzeugt wird, durch welches bei der Zielsignaleingabe basierend auf dem Detektionssignal die Leistungsversorgung der Last unterbrochen wird; und
die Leistungsversorgung der Last gemäß dem Steuersignal unterbrochen wird,
wobei es sich bei der Leistung um AC-Leistung handelt, wobei das Verfahren zur Leistungsunterbrechung **dadurch gekennzeichnet ist, dass** das Steuersignal basierend auf einem Vergleich erzeugt wird zwischen a) einer Sättigungsbreite, die einem Sättigungszeitintervall entspricht, bei welchem abhängig von einer Spezifikation eines Analog/Digitalwandlers (ADC) ein gesättigter digitaler ADC-Wert des Zielsignals bestimmt wird, und b) einem vorbestimmten Schwellenwertzeitintervall, und
wobei eine zeitliche Länge der Sättigungsbreite basierend auf dem ADC-Wert des Zielsignals innerhalb einer Halbperiode der Leistung bestimmt wird.

6. Verfahren zur Leistungsunterbrechung nach Anspruch 5, ferner umfassend, dass:
das Zielsignal durch Gleichrichten des Detektionssignals erzeugt wird, bevor das Steuersignal erzeugt wird.

7. Verfahren zur Leistungsunterbrechung nach Anspruch 5, wobei beim Erzeugen des Steuersignals ein Änderungsbetrag da des ADC-Wertes in jeder Abtastperiode dt für den ADC-Wert des Zielsignals berechnet wird und ein kumulativer Wert für da/dt berechnet wird, um das Steuersignal basierend auf der Sättigungsbreite für eine Zeit zu erzeugen, in welcher der kumulative Wert innerhalb eines vorbestimmten Bereichs gehalten wird, bevor der kumulative Wert im Anschluss an seinen Anstieg wieder absinkt.

8. Verfahren zur Leistungsunterbrechung nach Anspruch 7, wobei durch die Verwendung einer Kennlinie, bei welcher in einer zeitänderungsverschobenen Wellenform des ADC-Wertes sich eine Dimension einer Halbperioden-Wellenform der Leistung auf einer Zeitachse vergrößert, bis die Sättigung eintritt, und sich die Dimension der Wellenform nach der Sättigung verringert, und in dem Maß, in welchem sich eine Größe des Detektionssignals in einem Sättigungszustand vergrößert, sich die Sättigungsbreite und die Dimension der Wellenform verringern und sich eine Phase der Wellenform nahe bei einem Nulldurchgangspunkt des ansteigenden Signals befindet, das Steuersignal selbst dann für die Leistung mit hohem Leistungswert erzeugt wird, um die Leistungsversorgung der Last zu unterbrechen, wenn der Stromwandler (30) mit einer kleinen Kapazität und der entsprechende Analog-Digitalwandler angebracht sind.

9. Verfahren zur Leistungsunterbrechung nach Anspruch 7, wobei vor dem Erzeugen des Steuersignals das durch Gleichrichten des Detektionssignals gewonnene Zielsignal erzeugt wird und der nach Rücksetzen der AC-Leistung in jeder Halbperiode berechnete, kumulative Wert verwendet wird.

10. Verfahren zur Leistungsunterbrechung nach Anspruch 5, wobei beim Erzeugen des Steuersignals durch Bestimmen, ob während eines digitalen Analyseverarbeitungsprozesses für das Zielsignal ein gesättigter, digitaler Wert eines oder mehrerer vorbestimmter Grenzwerte gleich oder größer als ein Schwellenwert für die Momentanauslösung oder leckagebedingte Auslösung ist, bei einem Momentanüberstrom oder einem leckage- bzw. kurzschlussbedingten Überstrom auf der Lastseite die Leistungsversorgung der Last auf wirksame Weise unterbrochen wird.

11. Verfahren zur Leistungsunterbrechung nach Anspruch 5, wobei das Steuersignal abhängig davon erzeugt wird, ob die Sättigungsbreite für ein bzw. eine Mehrzahl von Detektionssignalen aus den Detektionssignalen, die von dem ZCT (20), dem Stromwandler (30) oder dem Spannungsdetektor (50) jeweils bereitgestellt werden, eine Bedingung erfüllt.

12. Verfahren zur Leistungsunterbrechung nach Anspruch 5, ferner umfassend, dass:
Daten des ADC-Wertes des Zielsignals während einer vorbestimmten Zeitspanne vor der Momentanauslösung oder leckagebedingten Auslösung in einem Speicher abgespeichert werden, und/oder ferner umfassend, dass:
ein Text oder ein Diagramm für die Daten des ADC-Wertes des Zielsignals in Echtzeit auf einer Anzeigevorrichtung angezeigt werden.

13. Leistungsunterbrechungsvorrichtung (100), umfassend:
einen ZCT (20), einen Stromwandler (30) oder einen Spannungsdetektor (50), die mit einer Leistungsversorgungsleitung gekoppelt sind, durch welche eine Last mit Leistung versorgt wird;
eine Hauptsteuereinheit (110), die in Abhängigkeit zum Auftreten eines Momentanüberstroms oder eines leckagebedingten Überstroms ein Auslöse-Steuersignal erzeugt, durch welches bei einer Zielsignaleingabe basierend auf einem von dem ZCT (20), dem Stromwandler (30) oder dem Spannungsdetektor (50) detektierten Detektionssignal die Leistungsversorgung der Last unterbrochen wird, wobei durch die Hauptsteuereinheit (110) basierend auf dem Detektionssignal ein ADC-Wert der Zielsignaleingabe erzeugt wird; und
einen Schutzschalter (120), der in der Lage ist, die Leistungsversorgung der Last gemäß dem Steuersignal zu unterbrechen,
wobei es sich bei der Leistung um AC-Leistung handelt,
wobei die Leistungsunterbrechungsvorrichtung **dadurch gekennzeichnet ist, dass**
die Hauptsteuereinheit (110) dafür ausgelegt ist, das Steuersignal basierend auf einem Vergleich zu erzeugen zwischen a) einem Zeitintervall (T1, T2, T3) zwischen Zeitpunkten, zu denen ein vorbestimmter Signalgrößenpegel des ADC-Wertes des Zielsignals bei aufeinanderfolgenden abfallenden und ansteigenden Signalen derselbe ist und b) einem ersten vorbestimmten Schwellenwertzeitintervall, wobei das Zeitintervall zwischen den Zeitpunkten, zu denen der Signalgrößenpegel derselbe ist, innerhalb einer Halbperiode der AC-Leistung bestimmt wird; oder dass
die Hauptsteuereinheit (110) dafür ausgelegt ist, das Steuersignal basierend auf einem Vergleich zu erzeugen zwischen a) einer Sättigungsbreite, die einem Sättigungszeitintervall entspricht, das davon abhängt, ob ein von einer Spezifikation eines Analog/Digitalwandlers abhängiger, gesättigter digitaler ADC-Wert des Zielsignals bestimmt wird, und b) einem zweiten vorbestimmten Schwellenwertzeitintervall, wobei eine zeitliche Länge der Sättigungsbreite basierend auf dem ADC-Wert des Zielsignals innerhalb einer Halbperiode der Leistung bestimmt wird.

## Revendications

1. Procédé d'interruption de puissance grâce à un dispositif d'interruption de puissance (100), comprenant :
la réception d'un signal de détection qui est détecté respectivement par un ZCT (20), un transformateur de courant (30) ou un détecteur de tension (50) qui sont couplés à une ligne d'alimentation en puissance grâce à laquelle une charge est alimentée en puissance ;
la génération d'une valeur CAN d'une entrée de signal cible sur la base du signal de détection ;
la génération d'un signal de commande de déclenchement en fonction de l'apparition d'une surintensité instantanée ou d'une surintensité due à un courant de fuite en vue d'interrompre l'alimentation en puissance de la charge lors d'une entrée de signal cible basée sur le signal de détection ; et
l'interruption de l'alimentation de la charge conformément au signal de commande, le signal de commande étant généré sur la base d'une comparaison entre a) un intervalle de temps (T1, T2, T3) entre des instants où un niveau de grandeur de signal prédéterminé de la valeur CAN du signal cible est le même pour des signaux descendants et des signaux montants successifs et b) un intervalle de temps seuil prédéterminé, la puissance étant une puissance CA, ledit procédé d'interruption de puissance étant **caractérisé en ce que** l'intervalle entre les instants où le niveau de grandeur de signal est le même est déterminé à l'intérieur d'une demi-période de la puissance CA.

2. Procédé d'interruption de puissance selon la revendication 1, comprenant en outre :
la génération du signal cible par redressement du signal de détection avant que ne soit généré le signal de commande, et de préférence
la détermination de l'intervalle en l'espace de 6 ms à partir d'un point de passage par zéro du signal montant pour une puissance CA de 60 Hz en tant que puissance.

3. Procédé d'interruption de puissance selon la revendication 1, dans lequel l'alimentation en puissance de la charge est interrompue de manière efficace lorsque, pendant la génération du signal de commande qui a lieu sur la base d'une comparaison entre l'intervalle et une valeur seuil pour le déclenchement instantané ou le déclenchement dû à un courant de fuite pour le signal cible, il survient, côté charge, une surintensité instantanée ou une surintensité due à un courant de fuite ou à un court-circuit.

4. Procédé d'interruption de puissance selon la revendication 1, dans lequel le signal de commande est généré dans le cas où une condition est satisfaite par l'intervalle entre les instants où le niveau de grandeur de signal prédéterminé est le même pour un signal de détection ou une pluralité de signaux de détection parmi les signaux de détection fournis respectivement par le ZCT (20), le transformateur de courant (30) ou le détecteur de tension (50).

5. Procédé d'interruption de puissance grâce à un dispositif d'interruption de puissance, comprenant :
la réception d'un signal de détection qui est détecté respectivement par un ZCT (20), un transformateur de courant (30) ou un détecteur de tension (50) qui sont couplés à une ligne d'alimentation en puissance grâce à laquelle une charge est alimentée en puissance ;
la génération d'une valeur CAN d'une entrée de signal cible sur la base du signal de détection ;
la génération d'un signal de commande de déclenchement en fonction de l'apparition d'une surintensité instantanée ou d'une surintensité due à un courant de fuite, ce qui permet d'interrompre l'alimentation en puissance de la charge dans le cas de l'entrée de signal cible basée sur le signal de détection ; et
l'interruption de l'alimentation en puissance de la charge conformément au signal de commande,
dans lequel la puissance est une puissance CA, ledit procédé d'interruption de puissance étant **caractérisé en ce que** le signal de commande est généré sur la base d'une comparaison entre a) une largeur de saturation qui correspond à un intervalle de saturation dans lequel est déterminée, en fonction d'une spécification d'un convertisseur analogique/numérique (CAN), une valeur CAN numérique saturée du signal cible et b) un intervalle de temps seuil prédéterminé, et
dans lequel une longueur temporelle de la largeur de saturation est déterminée sur la base de la valeur CAN du signal cible à l'intérieur d'une demi-période de la puissance.

6. Procédé d'interruption de puissance selon la revendication 5, comprenant en outre :
la génération du signal cible par redressement du signal de détection avant que ne soit généré le signal de commande.

7. Procédé d'interruption de puissance selon la revendication 5, dans lequel lors de la génération du signal de commande, un montant de variation da de la valeur CAN dans chaque période d'échantillonnage dt est calculée pour la valeur CAN du signal cible et une valeur cumulative pour da/dt est calculée afin de générer le signal de commande sur la base de la largeur de saturation, et ce pour une durée pendant laquelle la valeur cumulative est maintenue à l'intérieur d'une plage prédéterminée avant que ladite valeur cumulative ne diminue à nouveau après son augmentation.

8. Procédé d'interruption de puissance selon la revendication 7, dans lequel grâce à l'utilisation d'une caractéristique dans laquelle, dans une forme d'onde de la valeur CAN décalée dans le temps, une dimension d'une forme d'onde demi-périodique de la puissance augmente sur un axe temporel jusqu'à ce que la saturation apparaisse et que la dimension de la forme d'onde diminue une fois que la saturation a eu lieu, et à mesure qu'une grandeur du signal de détection augmente jusqu'à atteindre un état de saturation, la largeur de saturation et la dimension de la forme d'onde diminuent et une phase de la forme d'onde est proche d'un point de passage par zéro du signal montant, le signal de commande est généré pour la puissance ayant une puissance élevée afin d'interrompre l'alimentation en puissance de la charge même lorsqu'on utilise le transformateur de courant (30) de faible capacité et le convertisseur analogique-numérique correspondant.

9. Procédé d'interruption de puissance selon la revendication 7, dans lequel le signal cible obtenu par redressement du signal de détection est généré avant que ne soit généré le signal de commande, et dans lequel est utilisée la valeur cumulative calculée dans chaque demi-période après la réinitialisation de la puissance CA.

10. Procédé d'interruption de puissance selon la revendication 5, dans lequel lors de la génération du signal de commande qui s'effectue en déterminant si, pendant un processus de traitement numérique d'analyse du signal cible, une valeur numérique saturée d'une ou de plusieurs valeurs limites prédéterminées est égale ou supérieure à une valeur seuil pour le déclenchement instantanée ou le déclenchement dû à un courant de fuite, l'alimentation en puissance de la charge est interrompue de manière efficace lors de l'apparition, côté charge, d'une surintensité instantanée ou d'une surintensité due à un courant de fuite ou à un court-circuit.

11. Procédé d'interruption de puissance selon la revendication 5, dans lequel le signal de commande est généré dans le cas où une condition est satisfaite par la largeur de saturation pour un ou une pluralité de signaux de détection parmi les signaux de détection fournis respectivement par le ZCT (20), le transformateur de courant (30) ou le détecteur de tension (50).

12. Procédé d'interruption de puissance selon la revendication 5, comprenant en outre :
le stockage des données de la valeur CAN du signal cible dans une mémoire pendant une période de temps prédéterminée avant le déclenchement instantané ou le déclenchement dû à un courant de fuite, et/ou comprenant en outre :
l'affichage en temps réel d'un texte ou d'un diagramme pour les données de la valeur CAN du signal cible sur un dispositif d'affichage.

13. Dispositif d'interruption de puissance (100), comprenant :
un ZCT (20), un transformateur de courant (30) ou un détecteur de tension (50) qui sont couplés à une ligne d'alimentation en puissance grâce à laquelle une charge est alimentée en puissance ;
une unité de commande principale (110) grâce à laquelle est généré, en fonction de l'apparition d'une surintensité instantanée ou d'une surintensité due à un courant de fuite, un signal de commande de déclenchement qui interrompt l'alimentation en puissance de la charge dans le cas d'une entrée de signal cible basée sur un signal de détection détecté par le ZCT (20), le transformateur de courant (30) ou le détecteur de tension (50), une valeur CAN de l'entrée de signal cible étant générée par l'unité de commande principale (110) sur la base du signal de détection ; et
un disjoncteur (120) grâce auquel l'alimentation en puissance de la charge peut être interrompue conformément au signal de commande,
dans lequel la puissance est une puissance CA,
dans lequel ledit dispositif d'interruption de puissance est **caractérisé en ce que**
l'unité de commande principale (110) est configurée pour générer le signal de commande sur la base d'une comparaison entre a) un intervalle de temps (T1, T2, T3) entre des instants où un niveau de grandeur de signal prédéterminé de la valeur CAN du signal cible est le même pour des signaux descendants et des signaux montants successifs et b) un premier intervalle de temps seuil prédéterminé, l'intervalle entre les instants où le niveau de grandeur de signal est le même étant déterminé à l'intérieur d'une demi-période de la puissance CA ; ou **en ce que**
l'unité de commande principale (110) est configurée pour générer le signal de commande sur la base d'une comparaison entre a) une largeur de saturation correspondant à un intervalle de temps de saturation qui dépend de la détermination d'une valeur CAN numérique saturée du signal cible qui dépend d'une spécification d'un convertisseur analogique/numérique et b) un deuxième intervalle de temps seuil prédéterminé, une longueur temporelle de la largeur de saturation étant déterminée sur la base de la valeur CAN du signal cible à l'intérieur d'une demi-période de la puissance.
